# EUROPEAN PATENT SPECIFICATION

(11) **EP 4 009 350 B1**
(45) Date of publication and mention of the grant of the patent: **17.07.2024**
(21) Application number: 21200908.8
(22) Date of filing: 05.10.2021
(51) Int. Cl.: H01L 21/033, H01L 21/02, H01L 21/311

(54) **HARD MASK INCLUDING AMORPHOUS OR NANOCRYSTALLINE BORON NITRIDE FILM AND METHOD OF FABRICATING THE HARD MASK, AND PATTERNING METHOD USING THE HARD MASK**
HARTMASKE MIT EINER AMORPHEN ODER NANOKRISTALLINEN BORNITRIDSCHICHT UND VERFAHREN ZUR HERSTELLUNG DER HARTMASKE UND STRUKTURIERUNGSVERFAHREN UNTER VERWENDUNG DER HARTMASKE
MASQUE DUR COMPRENANT UN FILM DE NITRURE DE BORE AMORPHE OU NANOCRISTALLIN ET PROCÉDÉ DE FABRICATION DU MASQUE DUR ET PROCÉDÉ DE FORMATION DE MOTIFS À L'AIDE DU MASQUE DUR

(30) Priority: 03.12.2020 KR 20200167656
(43) Date of publication of application: 08.06.2022
(73) Proprietor: Samsung Electronics Co., Ltd., Suwon-si, Gyeonggi-do 16677 (KR)
(72) Inventor: SHIN, Hyeonjin, 16678 Suwon-si (KR); CHOI, Taejin, 16678 Suwon-si (KR)
(74) Representative: Elkington and Fife LLP

(56) References cited:
- EP-A1- 3 817 031
- EP-A1- 3 817 051
- US-A1- 2017 271 154

## Description

### FIELD OF THE INVENTION

The disclosure relates to a hard mask including an amorphous boron nitride film and a method of fabricating the hard mask, and a patterning method using the hard mask.

### BACKGROUND OF THE INVENTION

Recently, as the size of a semiconductor device gradually decreases, a structure having a high aspect ratio needs to be formed in an ultra-fine pattern of a nano size. However, it is difficult to accurately form an ultra-fine pattern of a high aspect ratio with a general lithography method using photoresist. To solve this problem, a hard mask having a higher etch selectivity than photoresist may be used.

Examples of a method of fabricating a hard mask, and a patterning method using the hard mask are disclosed in US 2017/271154 A1.

### SUMMARY OF THE INVENTION

According to the present invention, method of fabricating a hard mask is defined in claim 1, and a method of patterning a substrate is defined in claim 8. Preferred embodiments are defined in the dependent claims.

Additional aspects will be set forth in part in the description which follows and, in part, will be apparent from the description, or may be learned by practice of the presented embodiments of the disclosure.

In an example embodiment, a hard mask for patterning on a substrate is provided. The hard mask may include an amorphous boron nitride film on the substrate.

In some embodiments, the amorphous boron nitride film may have an amorphous structure including an sp³ hybrid bond and an sp² hybrid bond, and a ratio of the sp³ hybrid bond in the amorphous boron nitride film may be less than about 20%.

In some embodiments, a density of the amorphous boron nitride film may be about 1.8 g/cm³ or more.

A content ratio of boron to nitrogen in the amorphous boron nitride film may be about 0.5 to about 2.0.

A dielectric constant of the amorphous boron nitride film may be about 2.5 or less.

An energy bandgap of the amorphous boron nitride film may be about 6.0 eV or less.

A hydrogen content of the amorphous boron nitride film may be less than about 10 at%.

The amorphous boron nitride film may further include crystal grains having a size of several tens of nanometers.

The method of fabricating a hard mask includes forming an amorphous boron nitride film on a substrate, forming a photoresist layer on the amorphous boron nitride film, and forming the hard mask by patterning the amorphous boron nitride film using the photoresist layer.

In some embodiments, the amorphous boron nitride film may be formed on the substrate by a deposition process or a coating process.

In some embodiments, the amorphous boron nitride film may have an amorphous structure including an sp³ hybrid bond and an sp² hybrid bond, and a ratio of the sp³ hybrid bond in the amorphous boron nitride film is less than about 20%.

In some embodiments, the density of the amorphous boron nitride film may be about 1.8 g/cm³ or more.

In some embodiments, the forming the hard mask may include patterning the photoresist layer to provide a patterned photoresist layer, and etching the amorphous boron nitride film using the patterned photoresist layer.

In some embodiments, the method may further include, after forming the hard mask, removing the patterned photoresist layer.

In some embodiments, the etching the amorphous boron nitride film may be performed by dry etching using a certain etching gas.

The method of patterning a substrate includes forming an amorphous boron nitride film on a substrate, forming a hard mask by patterning the amorphous boron nitride film, and etching the substrate by using the hard mask.

In some embodiments, the forming the hard mask may include forming a photoresist layer on the amorphous boron nitride film, patterning the photoresist layer to provide a patterned photoresist layer, and etching the amorphous boron nitride film using the patterned photoresist layer.

Preferably, the method further includes, after forming the hard mask, removing the patterned photoresist layer.

In some embodiments, the etching the amorphous boron nitride film may be performed by dry etching using a first etching gas.

Preferably, the etching the substrate is performed by dry etching using a second etching gas.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a view of a hard mask according to an embodiment;
FIGS. 2A to 2G are views of a method of patterning a substrate using the hard mask of FIG. 1 after fabricating the hard mask of FIG. 1;
FIGS. 3A to 3C are views of a method of forming an amorphous boron nitride film;
FIGS. 4A and 4B are images respectively showing a transmission electron microscope (TEM) image and a diffraction pattern of an amorphous boron nitride film according to a TEM analysis result;
FIGS. 5A and 5B are images respectively showing a TEM image and a diffraction pattern of a nanocrystalline boron nitride film according to a TEM analysis result;
FIG. 6 is a view of the Raman spectrums of a crystalline boron nitride film, a nanocrystalline boron nitride film, and an amorphous boron nitride film;
FIG. 7 is a view of Fourier-transform infrared spectroscopy (FT-IR) spectrums with respect to the amorphous boron nitride film and the nanocrystalline boron nitride film;
FIGS. 8A and 8B, respectively, are views of X-ray photoelectron spectroscopy (XPS) profiles with respect to the amorphous boron nitride film and the nanocrystalline boron nitride film;
FIG. 9 is a view of a result of measurement of dielectric constants of the amorphous boron nitride film and the nanocrystalline boron nitride film;
FIG. 10 is a view of a result of simulation of density of the amorphous boron nitride film;
FIG. 11 is a graph of a relationship between a dielectric constant and a density in various materials;
FIG. 12 is a graph of a relationship between a dielectric constant and a breakdown field in various materials;
FIG. 13 is a graph of a breakdown bias according to a temperature of the amorphous boron nitride film;
FIG. 14 is a view of an FT-IR spectrum with respect to the amorphous boron nitride film;
FIG. 15A is a view of an analysis result of a high-resolution Rutherford backscattering spectroscopy (HR-RBS) of the amorphous boron nitride film;
FIG. 15B is a view of an analysis result of a high-resolution elastic recoil detection analysis (HR-ERDA) of the amorphous boron nitride film;
FIG. 16 is a view of an absorption rate of the crystalline boron nitride film, the nanocrystalline boron nitride film, and the amorphous boron nitride film, according to a light wavelength;
FIG. 17 is a view of an analysis result of a near edge X-ray absorption fine structure (NEXAFS) of the amorphous boron nitride film; and
FIGS. 18A and 18B are views of the Raman spectrum and an XPS analysis result of the amorphous boron nitride film transferred to a substrate.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of example embodiments. As used herein, the term "and/or" includes any and all combinations of one or more of the associated listed items. Expressions such as "at least one of," when preceding a list of elements, modify the entire list of elements and do not modify the individual elements of the list.

In the layer structure described below, when a constituent element is disposed "above" or "on" to another constituent element, the constituent element may include not only an element directly contacting on the upper/lower/left/right sides of the other constituent element, but also an element disposed above/under/left/right the other constituent element in a non-contact manner. The expression of singularity in the specification includes the expression of plurality unless clearly specified otherwise in context. It will be further understood that the terms "comprises" and/or "comprising" used herein specify the presence of stated features or components, but do not preclude the presence or addition of one or more other features or components

As used herein, the singular forms "a," "an" and "the" are intended to include the plural forms as well, unless the context clearly indicates otherwise. Also, the steps of all methods described herein can be performed in any suitable order unless otherwise indicated herein or otherwise clearly contradicted by context. The disclosure is not limited to the described order of the steps.

Furthermore, terms such as "portion," "unit," "module," and "block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

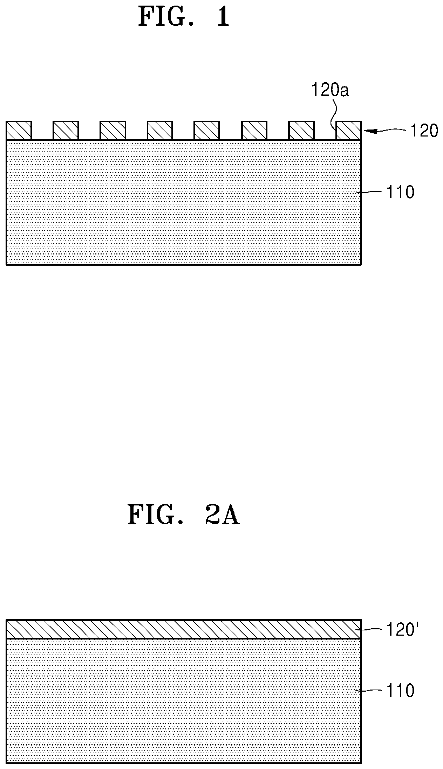

FIG. 1 is a view of a hard mask 120 according to an embodiment.

Referring to FIG. 1, the hard mask 120 is provided on a substrate 110. The substrate 110 may be a structure to be patterned by using the hard mask 120. The substrate 110 may include various devices that need patterning.

The hard mask 120 may function as an etch mask for etching the substrate 110. As the size of a semiconductor device gradually decreases, a structure having a high aspect ratio needs to be formed in an ultra-fine pattern of a nano size. To this end, the hard mask 120 having a higher etch selectivity than photoresist may be used.

An etching pattern 120a may be formed on the hard mask 120 in a certain shape. A desired structure may be implemented by etching, to a certain depth, the substrate 110 exposed through the etching pattern 120a of the hard mask 120. The etching of the substrate 110 may be performed by an anisotropic etching method using a certain etching gas.

The hard mask 120 includes an amorphous boron nitride film. In general, in order to manufacture a structure having a high aspect ratio using a hard mask, the hard mask may have a high etch selectivity and excellent mechanical characteristics. When the hard mask has a low etch selectivity or poor mechanical characteristics, the thickness of the hard mask 120 is increased. Also, when the thickness of the hard mask is increased, deformation phenomena such as leaning, wiggling, and the like may occur. Furthermore, the hard mask may be easily removed after the etching process of the substrate is completed, and may need to have low stress, excellent adhesion to other layers, and have transparency. An amorphous boron nitride film may have all the above-described characteristics required for the hard mask.

In the following description, a crystalline boron nitride film, a nanocrystalline boron nitride film, and an amorphous boron nitride film are described.

A crystalline boron nitride film may mean a boron nitride film including crystal grains having a size of about 100 nm or more. The crystalline boron nitride film may include, for example, a hexagonal boron nitride film (h-BN) or a cubic boron nitride film (c-BN).

A nanocrystalline boron nitride film (nc-BN) may mean a boron nitride film including crystal grains having a size less than the crystalline boron nitride film. The nanocrystalline boron nitride film may include crystal grains having a size of about 100 nm or less. In detail, for example, the nanocrystalline boron nitride film may include crystal grains having a size of about 0.5 nm to about 100 nm. The crystal grains may be several tens of nanometers (e.g., 30 nm to about 100 nm or less).

An amorphous boron nitride film (a-BN) 120 may mean a boron nitride film having a non-crystalline structure. The amorphous boron nitride film 120 may include an sp³ hybrid bond and an sp² hybrid bond, in which a ratio of the sp³ hybrid bond in the amorphous boron nitride film 120 may be less than about 20%. The amorphous boron nitride film 120 may include a small amount of crystal grains having a size of about several nanometers, for example, about 3 nm or less.

In the amorphous boron nitride film 120, a content ratio of boron to nitrogen may be, for example, about 0.5 to about 2.0. In a specific example, the content ratio of boron to nitrogen may be about 0.9 to about 1.1. However, the disclosure is not limited thereto.

The amorphous boron nitride film 120 may include more hydrogen, but the hydrogen content may be relatively small. For example, the hydrogen content may be less than about 10 at% (atomic percent). As the hydrogen content in the amorphous boron nitride film 120 may be small, the amorphous boron nitride film 120 may be chemically stable.

The amorphous boron nitride film 120 may have a low refractive index. For example, a refractive index of the amorphous boron nitride film 120 may be about 1.0 to about 1.5 with respect to light in a wavelength range of about 100 nm to about 1000 nm.

The amorphous boron nitride film 120 may have a low dielectric constant. For example, a dielectric constant of the amorphous boron nitride film 120 may be about 2.5 or less. In detail, for example, the dielectric constant of the amorphous boron nitride film 120 may be about 1.0 to about 2.5.

The amorphous boron nitride film 120 may have a high density. For example, a density of the amorphous boron nitride film 120 may be about 1.8 g/cm³ or more. In detail for example, the density of the amorphous boron nitride film 120 may be about 1.8 g/cm³ to about 2.5 g/cm³. As such, as the amorphous boron nitride film 120 may have a high density, the amorphous boron nitride film 120 may have excellent mechanical characteristics.

An energy bandgap of the amorphous boron nitride film 120 may be about 6.0 eV or less. Furthermore, the surface roughness of the amorphous boron nitride film 120 may be 0.5 root-mean-square (rms) or less.

[Table 1] below shows an example test result of comparing the characteristics of existing material layers used as a hard mask and the amorphous boron nitride film. In [Table 1], "ACL" denotes an amorphous carbon layer, and "BACL" denotes an amorphous carbon layer doped with boron (B). "a-BN" denotes an amorphous boron nitride film.

**[Table 1]**

| | Etch Selectivity (vs. ACL) | Density (g/cm³) | Hardness (GPa) |
|---|---|---|---|
| ACL | 1 | 1.2 | - |
| BACL | 1.5 ∼ 1.6 | - | - |
| a-BN | 1 | 2.1 ∼ 2.3 | 11.3 |

Referring to [Table 1], it may be seen that the amorphous boron nitride film has excellent etch selectivity that is almost the same as the amorphous carbon layer. As the amorphous boron nitride film has a high density that is about twice that of the amorphous carbon layer, and has hardness greater than silicon having a hardness of 11 Gpa, the mechanical characteristics of the amorphous boron nitride film are excellent. Accordingly, when the hard mask 120 includes an amorphous boron nitride film, the hard mask 120 may be fabricated to be thin, and the deformation phenomena such as leaning, wiggling, and the like may be limited and/or prevented. Furthermore, as the amorphous boron nitride film has excellent transparency compared to the amorphous carbon layer and the boron-doped amorphous carbon layer, the amorphous boron nitride film may have excellent processing properties compared to the amorphous carbon layer or the boron-doped amorphous carbon layer.

In the following description, a method of fabricating the hard mask 120 of FIG. 1, and a method of patterning the substrate 110 by using the hard mask 120, are described. FIGS. 2A to 2G are views of a method of patterning the substrate 110 using the hard mask 120 of FIG. 1 after fabricating the hard mask 120 of FIG. 1.

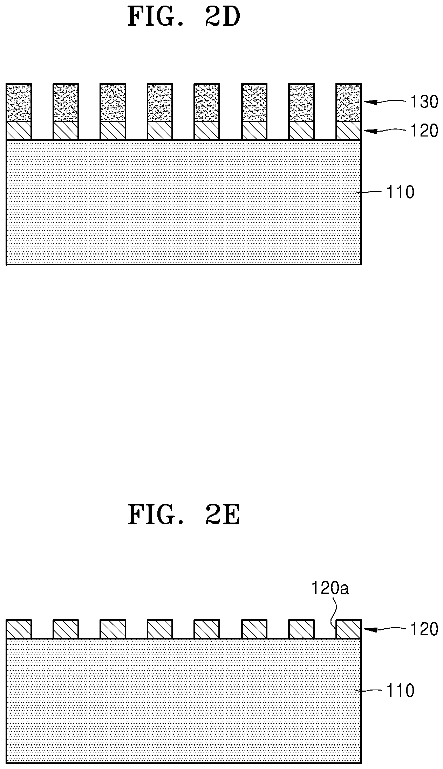

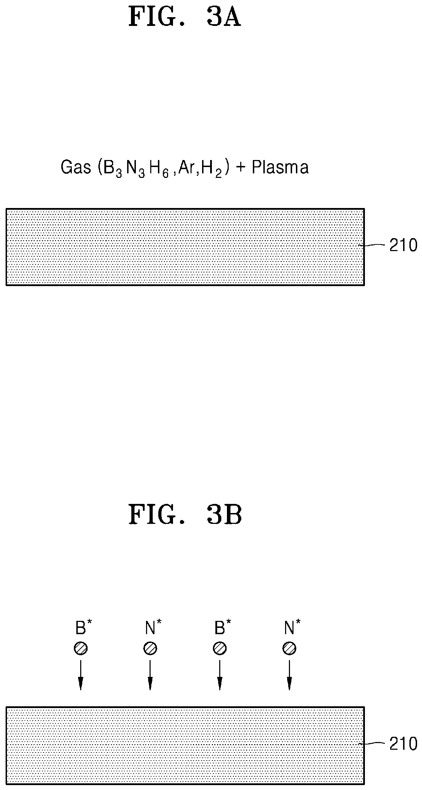

Referring to FIG. 2A, after the substrate 110 is prepared, an amorphous boron nitride film 120' is formed on the substrate 110. The substrate 110 may be a structure to be patterned by using a hard mask 120 (see FIG. 2E). The amorphous boron nitride film 120' may be formed on the substrate 110 by deposition. Alternatively, the amorphous boron nitride film 120' may be formed on the substrate 110 by solution coating. A process of forming the amorphous boron nitride film 120' by deposition is illustrated in FIGS. 3A to 3C, which is described below.

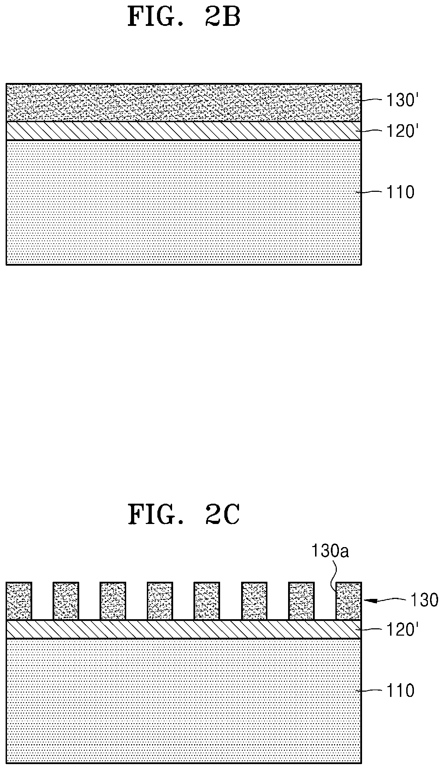

Referring to FIG. 2B, a photoresist layer 130' is formed to a certain thickness on an upper surface of the amorphous boron nitride film 120'. Referring to FIG. 2C, the photoresist layer 130' is patterned in a certain shape by using a photolithography process. In detail, after a photomask (not shown) is provided above the photoresist layer 130', light of a certain wavelength, for example, an ultraviolet ray, is irradiated to the photoresist layer 130' through a photomask, thereby performing an exposure process. Next, a patterned photoresist layer 130 is formed by performing a development process on the photoresist layer 130' that is exposed. A certain etching pattern 130a for exposing the amorphous boron nitride film 120' is formed on the patterned photoresist layer 130.

Referring to FIG. 2D, the hard mask 120 is formed by etching the amorphous boron nitride film 120' by using the patterned photoresist layer 130 as an etching mask. The etching process of the amorphous boron nitride film 120' may be performed by anisotropically etching the amorphous boron nitride film 120' exposed through the etching pattern 130a formed in the patterned photoresist layer 130 by using an etching gas. The first etching gas may include a gas capable of optionally etching only the amorphous boron nitride film 120'. For example, when the substrate 110 includes silicon, the first etching gas may include oxygen, but the disclosure is not limited thereto.

Referring to FIG. 2E, the patterned photoresist layer 130 left in the hard mask 120 is removed. The etching pattern 120a that exposes the substrate 110 is formed on the hard mask 120 formed on the substrate 110.

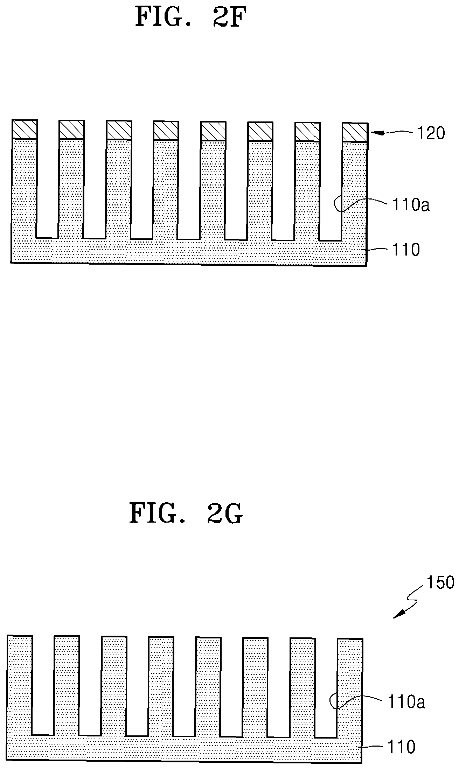

Referring to FIG. 2F, the substrate 110 is etched to a certain depth by using the hard mask 120 as an etching mask. The etching process of the substrate 110 may be formed by anisotropically etching the substrate 110 exposed through the etching pattern 120a formed on the hard mask 120 by using a second etching gas. The second etching gas may include a gas capable of optionally etching only the substrate 110. For example, when the substrate 110 includes silicon, the second etching gas may include a gas containing fluorine (F) such as CF₄, SF₆, or C₂F₆, and the like, but the disclosure is not limited thereto.

Referring to FIG. 2G, by removing the hard mask 120 left in the substrate 110, a patterned structure 150 including a groove 110a or a through-hole to certain depth may be obtained. The hard mask 120 may be easily removed from the patterned structure 150 through, for example, ashing and the like.

As described above, as the hard mask 120 is formed as the amorphous boron nitride film 120' having a high etch selectivity and excellent mechanical characteristics the patterned structure 150 having a high aspect ratio may be uniformly and precisely implemented in a desired shape.

In the following description, a method of forming the amorphous boron nitride film 120 described above using plasma enhanced chemical vapor deposition (PECVD) is described. FIGS. 3A to 3C are views of a method of forming an amorphous boron nitride film according to an embodiment.

Referring to FIG. 3A, a substrate 210 is prepared in a process chamber (not shown). The substrate 210 may become a structure to be patterned. The substrate 210 may be a substrate for growth of an amorphous boron nitride film 220 of FIG. 2C. The substrate 210 may include various materials.

The substrate 210 may include at least one of a semiconductor material, an insulating material, or metal. The semiconductor material may include Group IV semiconductors or semiconductor compounds. The Group IV semiconductors may include, for example, Si, Ge, Sn, and the like, but the disclosure is not limited thereto. The semiconductor compound may include a material obtained by combining at least two elements of, for example, Si, Ge, C, Zn, Cd, Al, Ga, In, B, C, N, P, S, Se, As, Sb, or Te. However, the disclosure is not limited thereto.

The Insulating material may include at least one of an oxide, a nitride, a carbide, or a derivative thereof of at least one of, for example, Si, Ni, Al, W, Ru, Co, Mn, Ti, Ta, Au, Hf, Zr, Zn, Y, Cr, Cu, Mo, or Gd. Furthermore, the substrate 210 may further include, for example, N or F in a SiCOH-based composition, and may include pores to lower permittivity. The substrate 210 may further include a dopant. However, the above-described materials of the substrate 210 are merely examples.

Before the substrate 210 is arranged in the process chamber, the substrate 110 may be pre-treated. For example, the substrate 210 may undergo an ultrasound-treatment by being dipped in an organic solvent such as acetone, and then may be cleaned with iso-propenyl alcohol (IPA) and nitrogen gas. By performing a plasma treatment using oxygen hydrogen, NH₃, and the like on the cleaned surface of the substrate 210, carbon impurities remaining on the surface may be removed. Furthermore, a natural oxide may be removed by dipping the substrate 210 in an HF solution, and a residual HF solution may be removed by using anhydrous ethanol nitrogen gas.

A process temperature to grow the amorphous boron nitride film 220 may be lower than a temperature used in a typical chemical vapor deposition (CVD) process. The process temperature to grow the amorphous boron nitride film 220 may be about 400°C or less. For example, the process temperature to grow the amorphous boron nitride film 220 may be about 15°C to about 400°C. When the process temperature is greater than about 400°C and about 700°C or less, a nanocrystalline boron nitride film may be formed, but the disclosure is not necessarily limited thereto.

A process pressure to grow the amorphous boron nitride film 220 may be about 50 mTorr or more. For example, the process pressure to grow the amorphous boron nitride film 220 may be about 10 mTorr to about 1 Torr.

Next, a reaction gas to grow the amorphous boron nitride film 220 is injected into the process chamber. The reaction gas may include a boron nitride source to grow the amorphous boron nitride film 220.

The boron nitride source may be a source including both of nitrogen and boron such as borazine (B₃N₃H₆), ammonia-borane (NH₃-BH₃), and the like. Furthermore, the boron nitride source may include a nitrogen source including nitrogen and a boron source including boron. The nitrogen source may include at least one of, for example, ammonia (NH₃) or nitrogen (N₂), and the boron source may include at least one of BH₃, BF₃, BCl₃, B₂H₆, (CH₃)₃B, and (CH₃ CH₂)₃B.

The reaction gas may further include an inert gas. The inert gas may include at least one of, for example, argon gas, neon gas, nitrogen gas, helium gas, krypton gas, or xenon gas. Furthermore, the reaction gas may further include hydrogen gas to promote activation by plasma. FIG. 3A illustrates an example in which borazine (B₃N₃H₆) is used as the boron nitride source and argon gas is used as the inert gas.

A mixing ratio of the reaction gas injected into the process chamber may be adjusted by controlling flow rates of the boron nitride source, the inert gas, and the hydrogen gas injected into the process chamber. In order to form the amorphous boron nitride film 120', the content of the boron nitride source needs to be relatively small in reaction gas. To this end, the flow rate of the boron nitride source introduced into the process chamber may be relatively low.

The volume ratio of the boron nitride source and the inert gas injected into the process chamber to form the amorphous boron nitride film 220 may be, for example, about 1:10-5000, and the volume ratio of the boron nitride source, the inert gas, and the hydrogen gas may be, for example, about 1:10-5000:10-500.

As such, as the volume ratio of the boron nitride source in the reaction gas is small, the amorphous boron nitride film 220 hardly having crystallinity may be formed on the surface of the substrate 210.

When an excessive amount of the boron nitride source is supplied into the process chamber, the amorphous boron nitride film 220 may grow irregularly and adsorption of a precursor may occur. To limit and/or prevent these issues, the flow rate of the boron nitride source may be low. For example, the flow rate of the boron nitride source may be about 0.05 standard cubic centimeters (sccm), and the flow rate of the inert gas may be about 50 sccm, but the disclosure is not limited thereto. Furthermore, the flow rate of the hydrogen gas may be about 50 sccm or more, but the disclosure is not limited thereto.

Next, in a process of introducing the reaction gas into the process chamber, plasma may be generated in the process chamber by a plasma apparatus. Power to generate plasma may be, for example, about 10 W to about 4000 W. In a specific example, the power to generate plasma may be about 60 W, but the disclosure is not limited thereto.

The plasma apparatus may be an apparatus that provides inductively coupled plasma (ICP), microwave plasma, capacitively coupled discharge plasma, electron cyclotron resonance plasma (ECR plasma), helicon plasma, and the like, but the disclosure is not limited thereto. When the power to generate plasma is applied from the plasma apparatus into the process chamber, an electric field is induced in the process chamber and plasma to grow the amorphous boron nitride film 220 may be generated by the induced electric field.

Referring to FIG. 3B, nitrogen atoms and boron atoms may be activated by the plasma of the reaction gas in which the boron nitride source, the inert gas, and the hydrogen gas are mixed with each other, and an activated nitrogen atom (N*) and an activated boron atom (B*) may be adsorbed on the surface of the substrate 210. As the plasma of the inert gas continuously induces activation of the substrate 210, the adsorption of the activated nitrogen (N*) and the activated boron (B*) on the surface of the substrate 210 may be accelerated.

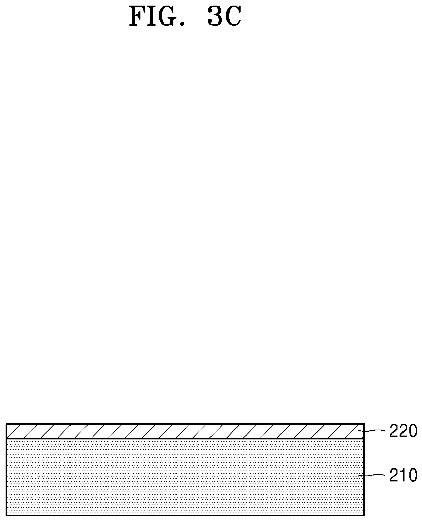

Referring to FIG. 3C, as the adsorption of the activated nitrogen (N*) and the activated boron (B*) on the surface of the substrate 210 is accelerated, the amorphous boron nitride film 220 may grow on the surface of the substrate 210. As a relatively low content of the activated nitrogen (N*) and the activated boron (B*) is adsorbed on the surface of the substrate 210 at a low temperature, that is, a temperature of 400°C or less, the amorphous boron nitride film 220 hardly having crystallinity may grow to be formed on the surface of the substrate 210.

When the amorphous boron nitride film 220 is grown on a structure to be patterned, the hard mask 120 of FIG. 1 may be fabricated by patterning the amorphous boron nitride film 220.

The amorphous boron nitride film 220 formed by the above-described method has an amorphous structure including an sp³ hybrid bond and an sp² hybrid bond, in which a ratio of the sp³ hybrid bond in the amorphous boron nitride film 220 may be less than about 20%. The ratio of sp³ hybrid bond in the amorphous boron nitride film 220 may be measured through, for example, an X-ray photoelectron spectroscopy (XPS) analysis. The amorphous boron nitride film 220 may additionally include crystal grains having a size of several nanometers, for example, about 3 nm or less.

In a process of forming the amorphous boron nitride film 220 described above, a nanocrystalline boron nitride film may be formed by changing process conditions, for example, a process temperature, a process pressure, and the like. The nanocrystalline boron nitride film may include crystal grains having a size of about 100 nm or less.

In the amorphous boron nitride film 220, the content ratio of boron to nitrogen may be, for example, about 0.5 to about 2.0. In a specific example, the content ratio of boron to nitrogen may be about 0.9 to about 1.1. Furthermore, the amorphous boron nitride film 220 may further include hydrogen. In this case, the hydrogen content may be, for example, less than about 10 at%.

The amorphous boron nitride film 220 may have a low refractive index of about 1.0 to about 1.5 with respect to the light in a wavelength range of about 100 nm to about 1000 nm. Furthermore, the amorphous boron nitride film 220 may have a low dielectric constant of about 2.5 or less. In detail, for example, the dielectric constant of the amorphous boron nitride film 220 may be about 1.0 to about 2.5.

The amorphous boron nitride film 220 may have a high density of about 1.8 g/cm³ or more. The amorphous boron nitride film 220 may have a surface roughness of about 0.5 rms or less. The amorphous boron nitride film 220 may have an energy bandgap of about 6.0 eV or less.

The amorphous boron nitride film 220 described above may function as an anti-reflection film as illustrated in FIG. 1. A device may be fabricated by forming other layers on the amorphous boron nitride film 220. Furthermore, the amorphous boron nitride film 220 may be separated from the substrate 210 to be transferred to another substrate or device and may function as an anti-reflection film.

[Table 2] shows an example test result of comparing the characteristics of a crystalline boron nitride film (in detail, h-BN), a nanocrystalline boron nitride film (nc-BN), and an amorphous boron nitride film (a-BN).

**[Table 2]**

| | h-BN | nc-BN | a-BN |
|---|---|---|---|
| Refractive Index @ 633 nm | 2.16 | 1.8 ~ 2.3 | 1.37 |
| Density (g/cm³) | 2.1 | - | 2.1 ~ 2.3 |
| Dielectric Constant | 3 ~ 3.5 | 2.0 ~ 3.0 | 1.5 ~ 2.0 |
| Energy Bandgap (eV) | 6.05 | 5.85 | 5.96 |

Referring to [Table 2], it may be seen that the refractive index of the amorphous boron nitride film (a-BN) with respect to light of a wavelength of 633 nm is lower than the refractive indexes of the crystalline boron nitride film (h-BN and the nanocrystalline boron nitride film (nc-BN). The refractive index of the amorphous boron nitride film (a-BN) may be almost similar to the refractive index of air. Furthermore, it may be seen that the amorphous boron nitride film (a-BN) has excellent mechanical inertness because the amorphous boron nitride film (a-BN) has a density greater than the crystalline boron nitride film (h-BN). The amorphous boron nitride film has a dielectric constant less than the crystalline boron nitride film (h-BN) and the nanocrystalline boron nitride film (nc-BN).

It may be seen that the hexagonal boron nitride film (h-BN) has an energy band gap of about 6.05 eV, the amorphous boron nitride film (a-BN) has an energy band gap of about 5.96 eV, and the nanocrystalline boron nitride film (nc-BN) has an energy band gap of about 5.85 eV. In other words, the amorphous boron nitride film (a-BN) and the nanocrystalline boron nitride film (nc-BN) have an energy bandgap lower than the hexagonal boron nitride film (h-BN). Accordingly, it may be seen that the amorphous boron nitride film (a-BN) is chemically stable.

[Table 3] below shows an example test result of comparing the characteristics of SiO₂, a low refractive index polymer (low RI polymer), MgF₂, and the amorphous boron nitride film (a-BN).

**[Table 3]**

| | SiO₂ | Low RI Polymer | MgF₂ | a-BN |
|---|---|---|---|---|
| Refractive Index @ 622 nm | 1.46 | 1.4 ~ 1.7 | 1.37 | 1.37 |
| Density (g/cm³) | 2.2 | ~1 | 3.1 | 2.1 ~ 2.3 |
| Hardness (GPa) | 3.5 | < 0.1 | - | 11.3 |

Referring to [Table 3], the amorphous boron nitride film (a-BN) has a refractive index lower than SiO₂ and the low refractive index polymer. Furthermore, it may be seen that the amorphous boron nitride film (a-BN) has excellent mechanical inertness because the amorphous boron nitride film (a-BN) has a density greater than the low refractive index polymer and a hardness greater than the SiO₂ and the low refractive index polymer. Although MgF₂ has a low refractive index and a high density, a passivation film is needed due to oxidation and low chemical inertness.

As described above, it may be seen that the amorphous boron nitride film (a-BN) has excellent mechanical inertness because the amorphous boron nitride film (a-BN) has a low refractive index similar to air and high density and high hardness. Furthermore, the amorphous boron nitride film (a-BN) has excellent adhesion to other layers and also has excellent thermal and chemical inertness. The amorphous boron nitride film (a-BN) has a high transmittance to light in a visible light range in an ultraviolet range, and also has excellent diffusion barrier characteristics. As the amorphous boron nitride film (a-BN) may have a surface roughness of about 0.5 rms or less, the surface of the amorphous boron nitride film (a-BN) may be very uniformly formed.

In the following description, an analysis result of the measured characteristics of the amorphous boron nitride film (a-BN) according to an embodiment is described in detail. In the following drawings, "a-BN" denotes a measurement result of an amorphous boron nitride film formed at a process temperature of 400°C by inductively coupled plasma chemical vapor deposition (ICP-CVD), and "nc-BN" denotes a measurement result of a nanocrystalline boron nitride film formed at a process temperature of 700°C by ICP-CVD.

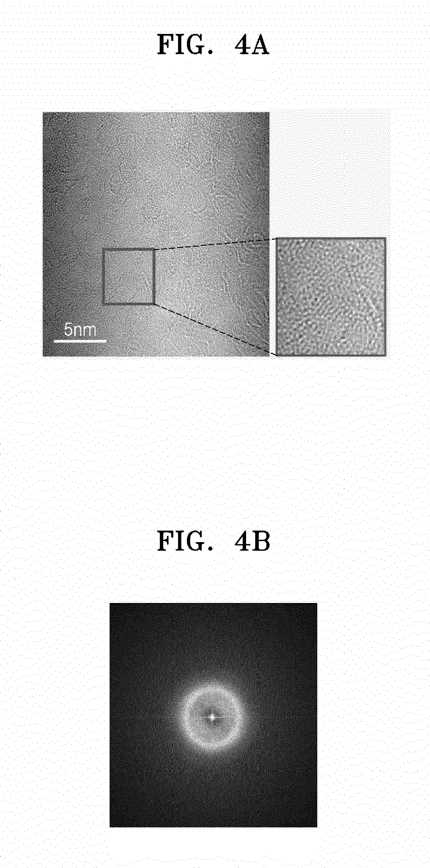

FIGS. 4A and 4B respectively illustrate a transmission electron microscope (TEM) image and a diffraction pattern of the amorphous boron nitride film (a-BN) according to a TEM analysis result. It may be seen from the TEM image of FIG. 4A that atoms constituting the amorphous boron nitride film (a-BN) are arranged in disorder, and that the diffraction pattern of FIG. 4B is a typical diffusion diffraction pattern of an amorphous film.

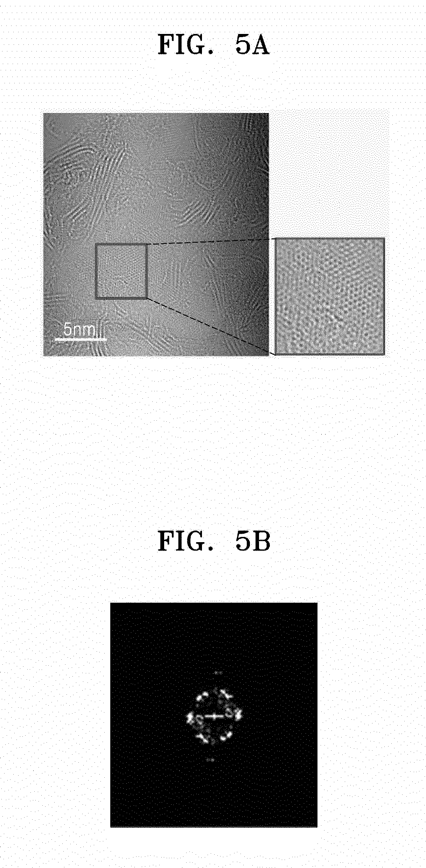

FIGS. 5A and 5B are views of a TEM image and a diffraction pattern of the nanocrystalline boron nitride film (nc-BN), according to a TEM analysis result. It may be seen from the result of FIGS. 5A and 5B that crystal grains having a nano size are arranged in the nanocrystalline boron nitride film (nc-BN). Accordingly, it may be seen that the nanocrystalline boron nitride film (nc-BN) may be formed at a process temperature of 700°C that is higher than 400°C.

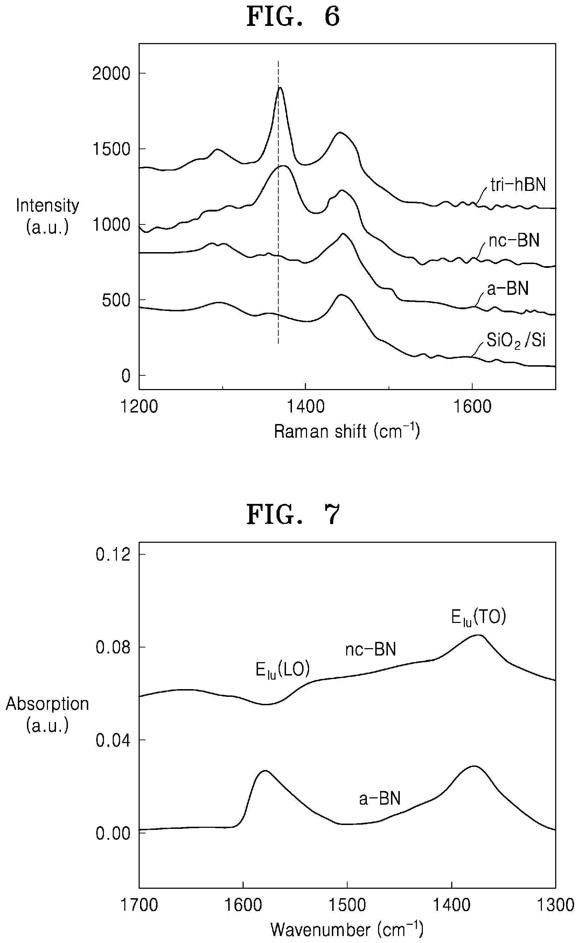

FIG. 6 are views of the Raman spectrums of the crystalline boron nitride film (h-BN), the nanocrystalline boron nitride film (nc-BN), and the amorphous boron nitride film (a-BN). In FIG. 6, "SiO₂/Si" denotes a Raman spectrum with respect to a SiO₂/Si substrate, and "a-BN" denotes a Raman spectrum measured after the amorphous boron nitride film (a-BN) is formed on the SiO₂/Si substrate at a process temperature of 400°C. "nc-BN" denotes a Raman spectrum measured after the nanocrystalline boron nitride film (nc-BN) is formed on the SiO₂/Si substrate at a process temperature of 700°C, and "Tri-BN" denotes a Raman spectrum measured after a hexagonal boron nitride film (h-BN) of three layers is epitaxially grown on the SiO₂/Si substrate.

Referring to FIG. 6, it may be seen that, in the Raman spectrum with respect to the hexagonal boron nitride film (h-BN) and the Raman spectrum with respect to the nanocrystalline boron nitride film (nc-BN), there is a peak at about 1370 cm⁻¹, and thus, the nanocrystalline boron nitride film (nc-BN) has crystallinity. In contrast, it may be seen that there is no peak in the Raman spectrum with respect to the amorphous boron nitride film (a-BN), and thus, the amorphous boron nitride film (a-BN) has no crystallinity.

FIG. 7 is a view of a Fourier-transform infrared spectroscopy (FT-IR) spectrum with respect to the amorphous boron nitride film (a-BN) and the nanocrystalline boron nitride film (nc-BN). FIG. 7 illustrates an FT-IR spectrum that is measured at an incident angle of 60° using s-polarized light.

Referring to FIG. 7, it may be seen that, in the FT-IR spectrum with respect to the amorphous boron nitride film (a-BN), there is an absorption peak due to a traverse optical mode at around about 1370 cm⁻¹, and there is another absorption peak at around 1570 cm ⁻¹. This means that the amorphous boron nitride film (a-BN) has amorphous characteristics.

It may be seen that, in the FT-IR spectrum with respect to the nanocrystalline boron nitride film (nc-BN), there is an absorption peak due to a traverse optical mode at around about 1370 cm⁻¹, but there is no absorption peak at around 1570 cm⁻¹. This means that the nanocrystalline boron nitride film (nc-BN) has no amorphous characteristics.

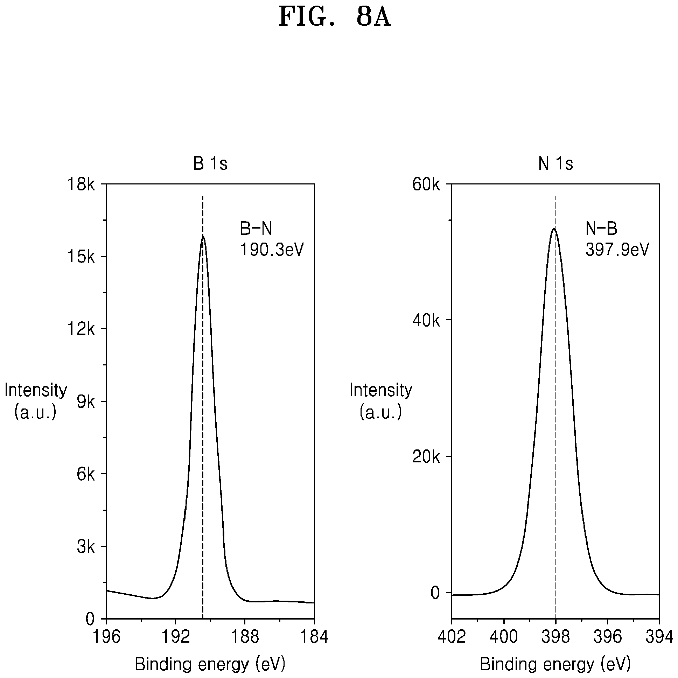

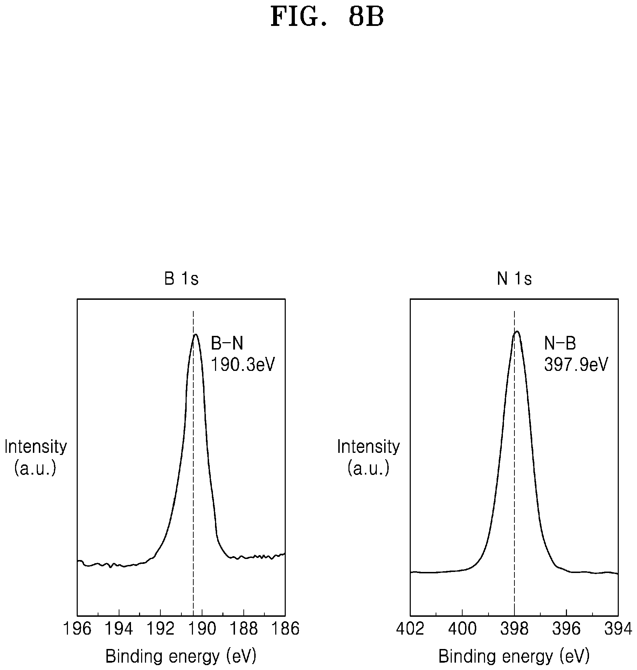

FIG. 8A illustrates an X-ray photoelectron spectroscopy (XPS) profile with respect to the amorphous boron nitride film (a-BN). FIG. 8B illustrates an XPS profile with respect to the nanocrystalline boron nitride film (nc-BN).

It may be seen that, in the XPS profile of FIG. 8A, a peak with respect to 1s of boron is 190.4 eV, and a peak with respect to 1s of nitrogen is 397.9 eV. It may be seen that an atomic ratio of boron and nitrogen in the amorphous boron nitride film (a-BN) is about 1:1.08 based on the peak size of boron and nitrogen. The amorphous boron nitride film (a-BN) may include an sp³ hybrid bond and an sp² hybrid bond, in which a ratio of the sp³ hybrid bond in the amorphous boron nitride film (a-BN) may be less than about 20%.

It may be seen that, in the XPS profile of FIG. 8B, a peak with respect to 1s of boron is 190.4 eV, and a peak with respect to 1s of nitrogen is 397.9 eV. It may be seen that the peak with respect to 1s of boron and the peak with respect to 1s of nitrogen in the nanocrystalline boron nitride film (nc-BN) almost match a peak with respect to 1s of boron and a peak with respect to 1s of nitrogen in the amorphous boron nitride film (a-BN). Accordingly, it may be seen that the atomic ratio of boron and nitrogen in the nanocrystalline boron nitride film (nc-BN) is about 1:1.08

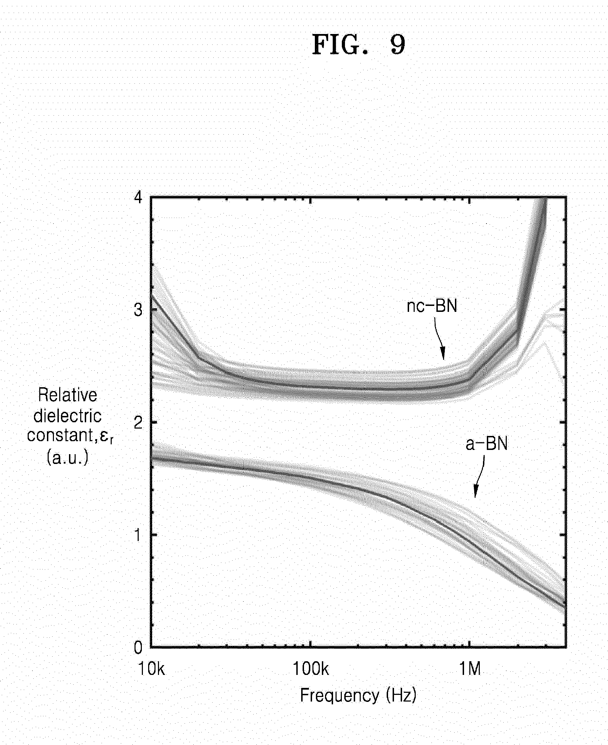

FIG. 9 is a view of a result of measurement of dielectric constants of the amorphous boron nitride film (a-BN) and the nanocrystalline boron nitride film (nc-BN). FIG. 9 illustrates results of measurements of a dielectric constant 50 times or more, and a thick line denotes an average dielectric constant.

Referring to FIG. 9, the dielectric constant of the amorphous boron nitride film (a-BN) is inversely proportional to an operating frequency. It may be seen that an average dielectric constant of the amorphous boron nitride film (a-BN) at an operating frequency of 100 kHz is about 1.78. It may be seen that, at an operating frequency of 1 MHz, the average dielectric constant of the amorphous boron nitride film (a-BN) is about 1.16, which is close to the dielectric constant of air or vacuum. As such, a low dielectric constant of the amorphous boron nitride film (a-BN) is caused by a nonpolar bonding between a boron atom and a nitrogen atom. A dielectric constant may be further lowered by forming pores in the amorphous boron nitride film (a-BN).

It may be seen that the average dielectric constant of the nanocrystalline boron nitride film (nc-BN) is about 2.5 or less in an operating frequency range of about 50 kHz to about 1 MHz. For example, the average dielectric constant of the nanocrystalline boron nitride film (nc-BN) may be about 2.3 to about 2.5. The average dielectric constant of the hexagonal boron nitride film (h-BN) is measured to be about 2.9 to about 3.8 at an operating frequency range of about 50 kHz to about 1 MHz.

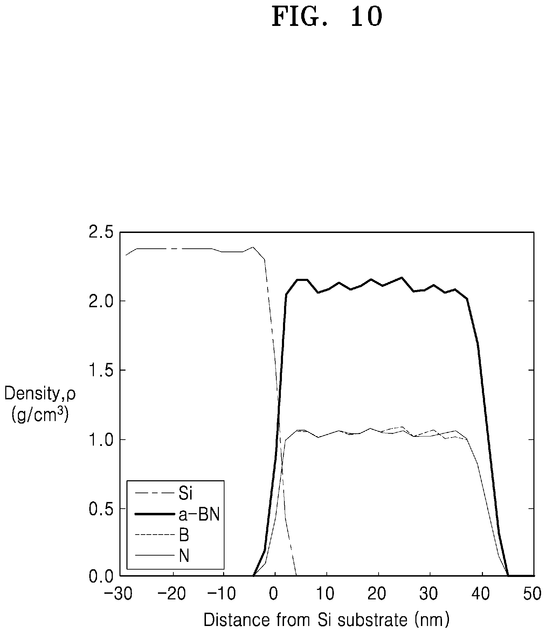

FIG. 10 is a view of a result of simulation of the density of the amorphous boron nitride film (a-BN). After the amorphous boron nitride film (a-BN) having a thickness of 40 nm is grown on a Si substrate, a mass density according to a thickness direction of the amorphous boron nitride film (a-BN) is simulated on the Si substrate.

Referring to FIG. 10, it may be seen that the mass density of the amorphous boron nitride film (a-BN) is about 2 g/cm³. As described below, it may be seen that, although the dielectric constant of the amorphous boron nitride film (a-BN) is low, the density thereof is high so that a mechanical strength thereof is not lowered.

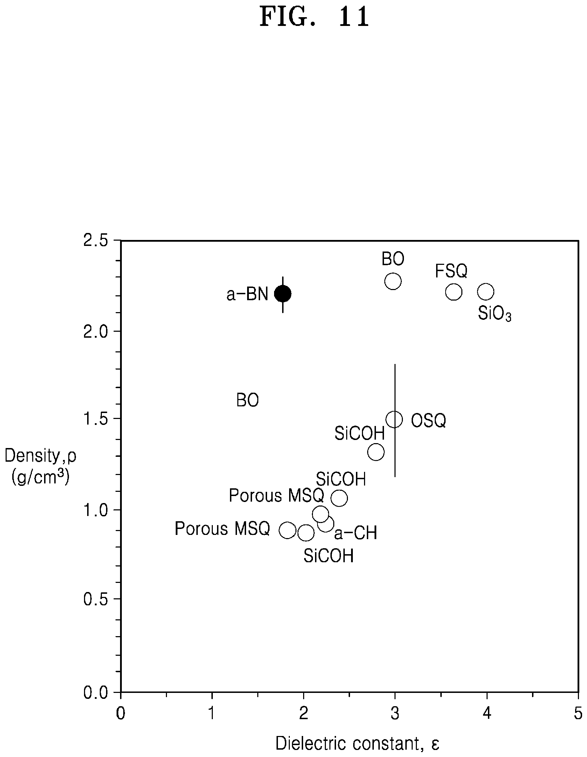

FIG. 11 is a graph of a relationship between a dielectric constant and a density in various materials.

Referring to FIG. 11, the dielectric constant and density of most materials are proportional to each other. Accordingly, in general, as a material having a low dielectric constant has a low density, a mechanical strength thereof may be low. However, the amorphous boron nitride film (a-BN) has a density of about 2 g/cm³ when the dielectric constant thereof is about 2. Thus, the amorphous boron nitride film (a-BN) may have a high mechanical strength because the density of the amorphous boron nitride film (a-BN) is relatively high compared to other materials.

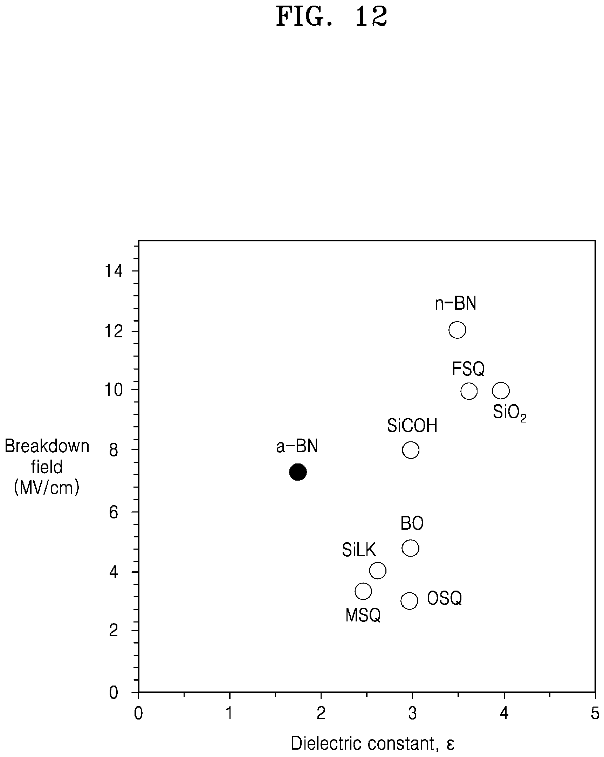

FIG. 12 is a graph of a relationship between a dielectric constant and a breakdown field in various materials.

Referring to FIG. 12, it may be seen that the dielectric constant and the breakdown field are proportional to each other. It may be seen that, compared to other materials having a dielectric constant close to 2, the breakdown field of the amorphous boron nitride film (a-BN) is higher than the other materials.

[Table 4] below shows an example test result of measuring the dielectric constants and breakdown fields of the amorphous boron nitride film (a-BN) and the hexagonal boron nitride film (h-BN).

**[Table 4]**

| | Dielectric Constant @ 100 kHz / @ 1 MHz | Breakdown Field (MV/cm) |
|---|---|---|
| h-BN | 3.28/2.87 | 2.2 |
| a-BN | 1.78/1.16 | 7.3 |

Referring to [Table 4], it may be seen that, as the dielectric constant of the amorphous boron nitride film (a-BN) is less than or equal to 2 at operating frequencies of about 100 kHz and about 1 MHz, the dielectric constant of the amorphous boron nitride film (a-BN) is less than the dielectric constant of the hexagonal boron nitride film (h-BN). Furthermore, it may be seen that, as the breakdown field of the amorphous boron nitride film (a-BN) is about 7.3 MV/cm, the breakdown field of the amorphous boron nitride film (a-BN) is much greater than the breakdown field of the hexagonal boron nitride film (h-BN).

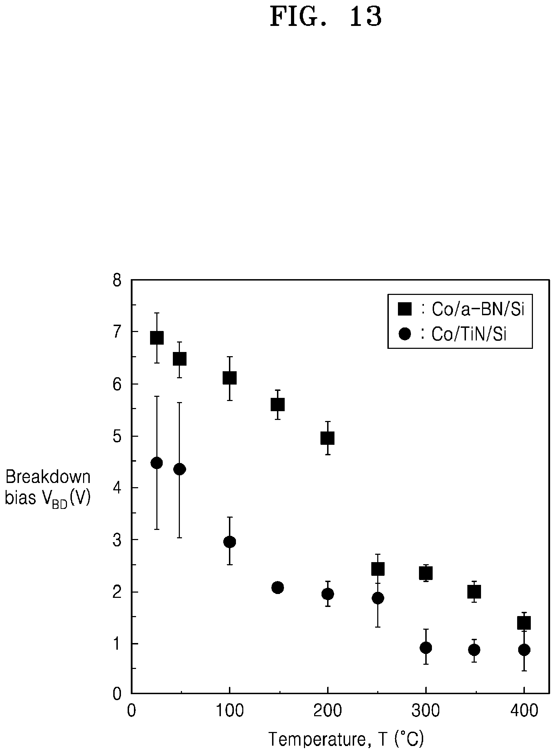

FIG. 13 is a graph of a breakdown bias according to the temperature of the amorphous boron nitride film (a-BN). In FIG. 13, "Co/a-BN/Si" denotes a case in which the amorphous boron nitride film (a-BN) and a Co layer are sequentially deposited on a Si substrate, and "Co/Ti/Si" denotes a case in which a Ti layer and a Co layer are sequentially deposited on a Si substrate.

Referring to FIG. 13, it may be seen that the breakdown bias of the amorphous boron nitride film (a-BN) is inversely proportional to a temperature. It may be seen that, even when the breakdown voltage decreases as the temperature increases, the breakdown bias of the amorphous boron nitride film (a-BN) is greater than the breakdown bias of the TiN layer. This means that the amorphous boron nitride film (a-BN) is stable at various temperatures.

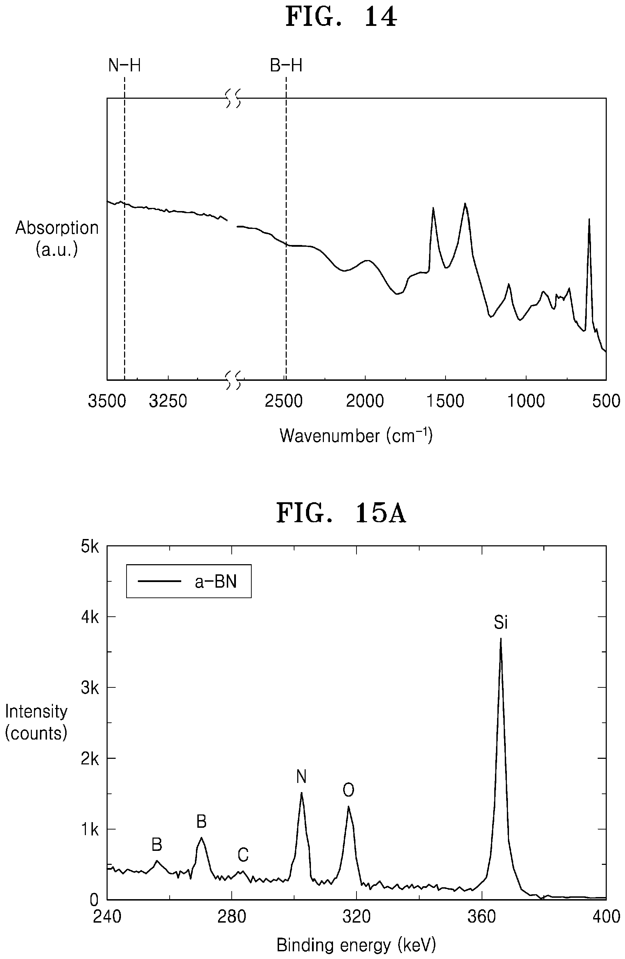

FIG. 14 is a view of an FT-IR spectrum with respect to the amorphous boron nitride film (a-BN). Referring to FIG. 14, it may be seen that there is no bond related to hydrogen in an FT-IR spectrum with respect to the amorphous boron nitride film (a-BN) because a peak is not observed in a wavenumber corresponding to a B-H bond and an N-H bond.

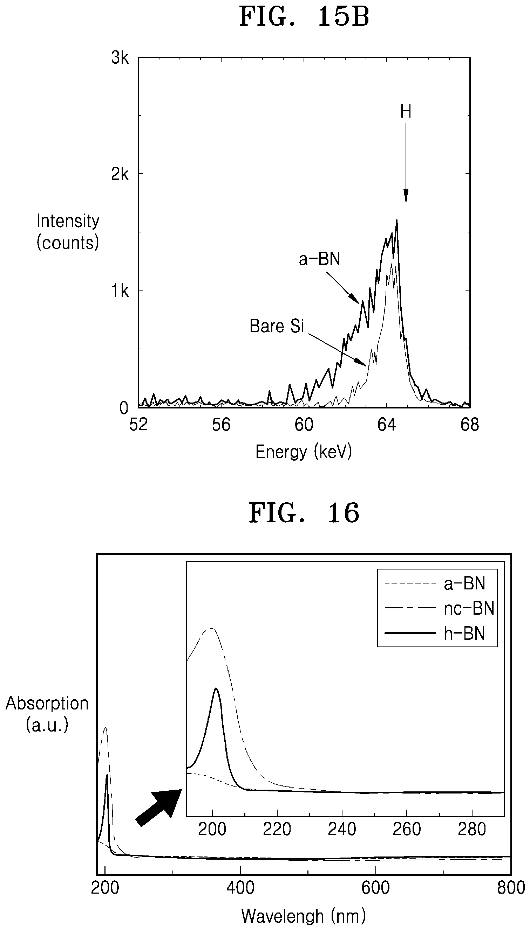

FIG. 15A is a view of an analysis result of a high-resolution Rutherford backscattering spectroscopy (HR-RBS) of the amorphous boron nitride film (a-BN). FIG. 15B is a view of an analysis result of high-resolution elastic recoil detection analysis (HR-ERDA) of the amorphous boron nitride film (a-BN).

FIG. 15A illustrates a result of a measurement in a binding energy range of about 240 keV to about 400 keV, and FIG. 15B illustrates a result of a measurement in a binding energy range of about 52 keV to about 68 keV. Referring to FIGS. 15A and 15B, it may be seen that Si and O that are elements of a substrate are measured, and B and N that are elements of the amorphous boron nitride film (a-BN) are measured. Furthermore, it may be seen that hydrogen is also measured.

[Table 5] below shows a composition ratio of the amorphous boron nitride film (a-BN) calculated using the measurement results illustrated in FIGS. 14A and 14B.

**[Table 5]**

| | B (at %) | N (at %) | H (at %) |
|---|---|---|---|
| a-BN | 47.6 | 46.9 | 5.5 |

Referring to [Table 5], it may be seen that a ratio of boron and nitrogen is about 1.04:1. Furthermore, it may be seen that a hydrogen content in the amorphous boron nitride film (a-BN) is about 5.5 at%.

FIG. 16 is a view of an absorption rate of the crystalline boron nitride film (h-BN), the nanocrystalline boron nitride film (nc-BN), and the amorphous boron nitride film (a-BN), according to a light wavelength. FIG. 16 illustrates an absorption rate with respect to light in an ultraviolet wavelength range.

Referring to FIG. 16, it may be seen that, while the crystalline boron nitride film (h-BN) and the nanocrystalline boron nitride film (nc-BN) have a high absorption rate with respect to light in a wavelength range of about 100 nm, the amorphous boron nitride film (a-BN) shows a high transmittance due to a low absorption rate for the light in a wavelength range of about 100 nm.

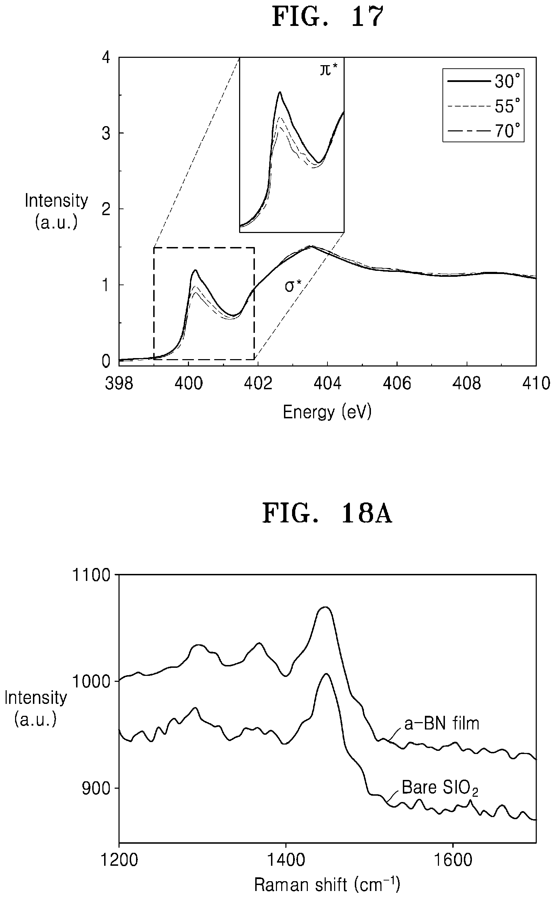

FIG. 17 is a view of an analysis result of a near edge X-ray absorption fine structure (NEXAFS) of the amorphous boron nitride film (a-BN). Referring to FIG. 17, it may be seen that B-N planes formed by the sp² hybrid bond in the amorphous boron nitride film (a-BN) are randomly oriented with a certain directivity.

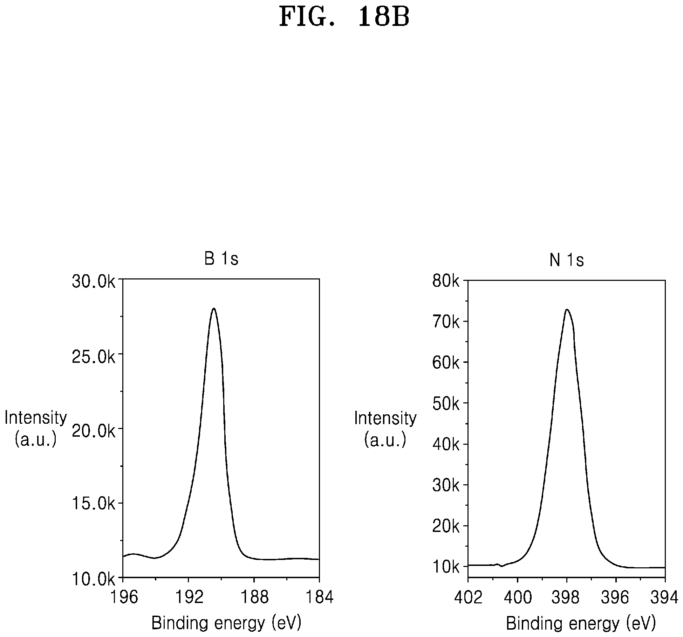

FIGS. 18A and 18B respectively illustrate the Raman spectrum and an XPS image of the amorphous boron nitride film (a-BN), which are transferred to a substrate.

FIG. 18A illustrates the Raman spectrum with respect to the amorphous boron nitride film (a-BN) transferred to an SiO₂ substrate. In FIG. 18A, "Bare SiO₂" denotes a Raman spectrum with respect to the SiO₂ substrate where the amorphous boron nitride film (a-BN) is not grown, and "a-Si film" denotes the Raman spectrum with respect to the amorphous boron nitride film (a-BN) transferred to the SiO₂ substrate. The amorphous boron nitride film (a-BN) is grown on a copper foil (Cu foil) at plasma power of about 30 W and a process temperature of about 300°C, and then transferred to the SiO₂ substrate. Referring to FIG. 18A, it may be seen that a result of the Raman spectrum with respect to the amorphous boron nitride film (a-BN) transferred to the SiO₂ substrate is similar to a result of the Raman spectrum with respect to an SiO₂ substrate where the amorphous boron nitride film (a-BN) is not grown. It may be seen from the above that the amorphous boron nitride film (a-BN) transferred to the SiO₂ has an amorphous structure like the SiO₂ substrate.

FIG. 18B is an XPS image of the amorphous boron nitride film (a-BN) transferred to the SiO₂. Referring to FIG. 18B, it may be seen that, in the amorphous boron nitride film (a-BN) transferred to the SiO₂, like the amorphous boron nitride film (a-BN) grown at a process temperature of 400°C as described above, a peak with respect to 1s of boron is about 190.4 eV, and a peak with respect to 1s of nitrogen is about 397.9 eV. It may be seen from the above that an atomic ratio of boron and nitrogen is about 1:1.08 and there is an sp² bond based on the peak size of each of boron and nitrogen.

As described above, as the amorphous boron nitride film has an excellent etch selectivity and high density and hardness, the mechanical characteristics of the amorphous boron nitride film are excellent. Accordingly, the hard mask may be fabricated to be relatively thin by using amorphous boron nitride film, and the deformation phenomena such as leaning, wiggling, and the like of the hard mask may be limited and/or prevented. Furthermore, the amorphous boron nitride film may be easily removed after a pattern is formed, may have low stress, and may have excellent adhesion to other layers. The amorphous boron nitride film, as an insulating film having high transparency, has excellent processability. Accordingly, a hard mask capable of uniformly and precisely implementing a structure having a high aspect ratio may be fabricated by using the amorphous boron nitride film.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein as long as these fall within the scope as defined by the following claims.

## Claims

1. A method of fabricating a hard mask, the method comprising:
forming an amorphous boron nitride film on a substrate;
forming a photoresist layer on the amorphous boron nitride film; and
forming the hard mask by patterning the amorphous boron nitride film using the photoresist layer.

2. The method of claim 1, wherein the amorphous boron nitride film is formed on the substrate by a deposition process or a coating process.

3. The method of claims 1 or 2, wherein
the amorphous boron nitride film has an amorphous structure comprising an sp³ hybrid bond and an sp² hybrid bond, and
a ratio of the sp³ hybrid bond in the amorphous boron nitride film is less than 20%.

4. The method of any of claims 1-3, wherein a density of the amorphous boron nitride film is 1.8 g/cm³ or more.

5. The method of any of claims 1-4, wherein the forming of the hard mask comprises:
patterning the photoresist layer to provide a patterned photoresist layer; and
etching the amorphous boron nitride film by using the patterned photoresist layer.

6. The method of claim 5, further comprising:
after forming the hard mask, removing the patterned photoresist layer.

7. The method of claims 5 or 6, wherein the etching the amorphous boron nitride film is performed by dry etching using a certain etching gas.

8. A method of patterning a substrate, the method comprising:
forming an amorphous boron nitride film on the substrate;
forming a hard mask by patterning the amorphous boron nitride film; and
etching the substrate by using the hard mask.

9. The method of claim 8, wherein the forming the hard mask comprises:
forming a photoresist layer on the amorphous boron nitride film;
patterning the photoresist layer to provide a patterned photoresist layer; and
etching the amorphous boron nitride film using the patterned photoresist layer;
preferably further comprising:
after forming the hard mask, removing the patterned photoresist layer.

10. The method of claim 9, wherein the etching the amorphous boron nitride film is performed by dry etching using a first etching gas;
preferably wherein the etching the substrate is performed by dry etching using a second etching gas.

## Patentansprüche

1. Verfahren zur Herstellung einer Hartmaske, wobei das Verfahren Folgendes umfasst:
Bilden eines amorphen Bornitridfilms auf einem Substrat;
Bilden einer Fotolackschicht auf dem amorphen Bornitridfilm; und
Bilden der Hartmaske durch Strukturieren des amorphen Bornitridfilms unter Verwendung der Fotolackschicht.

2. Verfahren nach Anspruch 1, wobei der amorphe Bornitridfilm auf dem Substrat durch einen Abscheidungsprozess oder einen Beschichtungsprozess gebildet wird.

3. Verfahren nach Anspruch 1 oder 2, wobei
der amorphe Bornitridfilm eine amorphe Struktur aufweist, die eine sp³-Hybridbindung und eine sp²-Hybridbindung umfasst, und
ein Anteil der sp³-Hybridbindung in dem amorphen Bornitridfilm weniger als 20 % ist.

4. Verfahren nach einem der Ansprüche 1-3, wobei eine Dichte des amorphen Bornitridfilms 1,8 g/cm³ oder mehr ist.

5. Verfahren nach einem der Ansprüche 1-4, wobei das Bilden der Hartmaske Folgendes umfasst:
Strukturieren der Fotolackschicht, um eine strukturierte Fotolackschicht bereitzustellen; und
Ätzen des amorphen Bornitridfilms durch Verwenden der strukturierten Fotolackschicht.

6. Verfahren nach Anspruch 5, ferner umfassend:
nach dem Bilden der Hartmaske Entfernen der strukturierten Fotolackschicht.

7. Verfahren nach Anspruch 5 oder 6, wobei das Ätzen des amorphen Bornitridfilms durch Trockenätzen unter Verwendung eines bestimmten Ätzgases durchgeführt wird.

8. Verfahren zur Strukturierung eines Substrats, wobei das Verfahren Folgendes umfasst:
Bilden eines amorphen Bornitridfilms auf dem Substrat;
Bilden einer Hartmaske durch Strukturieren des amorphen Bornitridfilms; und
Ätzen des Substrats durch Verwenden der Hartmaske.

9. Verfahren nach Anspruch 8, wobei das Bilden der Hartmaske Folgendes umfasst:
Bilden einer Fotolackschicht auf dem amorphen Bornitridfilm;
Strukturieren der Fotolackschicht, um eine strukturierte Fotolackschicht bereitzustellen; und
Ätzen des amorphen Bornitridfilms unter Verwendung der strukturierten Fotolackschicht;
bevorzugt ferner umfassend:
nach dem Bilden der Hartmaske Entfernen der strukturierten Fotolackschicht.

10. Verfahren nach Anspruch 9, wobei das Ätzen des amorphen Bornitridfilms durch Trockenätzen unter Verwendung eines ersten Ätzgases durchgeführt wird;
wobei bevorzugt das Ätzen des Substrats durch Trockenätzen unter Verwendung eines zweiten Ätzgases durchgeführt wird.

## Revendications

1. Procédé de fabrication d'un masque dur, le procédé comprenant :
la formation d'un film de nitrure de bore amorphe sur un substrat ;
la formation d'une couche de résine photosensible sur le film de nitrure de bore amorphe ; et
la formation du masque dur par la formation de motifs sur le film de nitrure de bore amorphe à l'aide de la couche de résine photosensible.

2. Procédé de la revendication 1, ledit film de nitrure de bore amorphe étant formé sur le substrat par un processus de dépôt ou un processus de revêtement.

3. Procédé des revendications 1 ou 2,
ledit film de nitrure de bore amorphe comportant une structure amorphe comprenant une liaison hybride sp³ et une liaison hybride sp², et
un rapport de la liaison hybride sp³ dans le film de nitrure de bore amorphe étant inférieur à 20 %.

4. Procédé de l'une quelconque des revendications 1-3, une densité de film de nitrure de bore amorphe étant supérieure ou égale à 1,8 g/cm³.

5. Procédé de l'une quelconque des revendications 1-4, ladite formation du masque dur comprenant :
la formation de motifs sur la couche de résine photosensible pour fournir une couche de résine photosensible à motifs ; et
la gravure du film de nitrure de bore amorphe à l'aide de la couche de résine photosensible à motifs.

6. Procédé de la revendication 5, comprenant en outre :
après la formation du masque dur, le retrait de la couche de résine photosensible à motifs.

7. Procédé de la revendication 5 ou 6, ladite gravure du film de nitrure de bore amorphe étant réalisée par gravure sèche à l'aide d'un certain gaz de gravure.

8. Procédé de formation de motifs sur un substrat, le procédé comprenant :
la formation d'un film de nitrure de bore amorphe sur le substrat ;
la formation d'un masque dur par la formation de motifs sur le film de nitrure de bore amorphe ; et
la gravure du substrat à l'aide du masque dur.

9. Procédé de la revendication 8, ladite formation du masque dur comprenant :
la formation d'une couche de résine photosensible sur le film de nitrure de bore amorphe ;
la formation de motifs sur la couche de résine photosensible pour fournir une couche de résine photosensible à motifs ; et
la gravure du film de nitrure de bore amorphe à l'aide de la couche de résine photosensible à motifs ;
de préférence, comprenant en outre :
après la formation du masque dur, le retrait de la couche de résine photosensible à motifs.

10. Procédé de la revendication 9, ladite gravure du film de nitrure de bore amorphe étant réalisée par gravure sèche à l'aide d'un premier gaz de gravure ;
de préférence, ladite gravure du substrat étant réalisée par gravure sèche à l'aide d'un second gaz de gravure.
